Europäisches Patentamt

European Patent Office

Office européen des brevets

(11) Veröffentlichungsnummer : **0 010 623**
**B1**

(12) **EUROPÄISCHE PATENTSCHRIFT**

(45) Veröffentlichungstag der Patentschrift :
22.09.82

(51) Int. Cl.³ : **H 01 L 21/283, H 01 L 21/263,**
**H 01 L 21/76**

(21) Anmeldenummer : 79103697.3

(22) Anmeldetag : 28.09.79

(54) Verfahren zur Herstellung einer Schichtstruktur für hochintegrierte Halbleiteranordnungen mit einer zwischen zwei leitenden Schichten angeordneten Isolierschicht.

(30) Priorität : 03.11.78 US 957606

(43) Veröffentlichungstag der Anmeldung :
14.05.80 (Patentblatt 80/10)

(45) Bekanntmachung des Hinweises auf die Patenterteilung : 22.09.82 Patentblatt 82/38

(84) Benannte Vertragsstaaten :
DE FR GB

(56) Entgegenhaltungen :
GB A 2 003 660

IBM TECHNICAL DISCLOSURE BULLETIN,
Band 20, Heft 10, März 1978 New York
C.G. JAMBOTKAR et al. « Fabrication
of power transistors » Seiten 3 977
bis 3 979
« Patents Abstracts of Japan »
Band 3, Heft 54, 10. Mai 1979
Seite 97 E 109
SOLID STATE TECHNOLOGY, Band 19, Heft 4,
April 1976 Port Washington PER G. GLÖERSEN
« Masking for ion beam etching » Seiten 68 bis 73

(73) Patentinhaber : International Business Machines Corporation
Armonk, N.Y. 10504 (US)

(72) Erfinder : Riseman, Jacob
38 Barnard Avenue
Poughkeepsie, New York, 12602 (US)

(74) Vertreter : Kreidler, Eva-Maria, Dr. rer. nat.
Schönaicher Strasse 220
D-7030 Böblingen (DE)

EP 0 010 623 B1

# Verfahren zur Herstellung einer Schichtstruktur für hochintegrierte Halbleiteranordnungen mit einer zwischen zwei leitenden Schichten angeordneten Isolierschicht

Die Erfindung bezieht sich auf ein Verfahren zur Herstellung einer Schichtstruktur für hochintegrierte Halbleiteranordnungen, bei dem jeweils eine Isolierschicht zur Trennung zweier leitender Schichten auf einer Unterlage vorzusehen ist, bei dem zunächst auf der Oberfläche der Unterlage Bereiche einer ersten leitenden Schicht ausgebildet werden, so daß im wesentlichen horizontale sowie im wesentlichen vertikale Oberflächen entstehen, und bei dem auf diese im wesentlichen horizontalen sowie im wesentlichen vertikalen Oberflächen eine diese bedeckende und sich daran anpassende Isolierschicht aufgebracht wird.

Die Komplexität integrierter Silicium-Schaltkreise hat in den letzten zehn Jahren erheblich zugenommen. Mit zunehmender Erschließung von Anwendungsgebieten für Mikroprozessoren und Kleinrechner ergab sich ein entsprechend zunehmendes Bedürfnis für eine gesteigerte Komplexität, höhere Schaltgeschwindigkeit und kleinere Abmessungen solcher integrierter Schaltkreise. Im Rahmen der Halbleiterprozesse erlaubt in erster Linie die Lithographie eine Steigerung der Komplexität der integrierten Schaltkreise. In den letzten Jahren konnten lediglich mäßige Verringerungen der erzielbaren (minimalen) Linienbreite integrierter Strukturen erreicht werden. Die hohen Steigerungen der Integrationsdichte wurden in erster Linie durch eine Senkung der photolithographischen Defektdichten erzielt. Dabei erfolgte eine allmähliche Verringerung der Linienbreiten von etwa 5 bis 10 μm auf heute etwa 3 bis 5 μm. Nahezu ausschließlich wurde ferner bisher Licht im Rahmen der Lithographieprozesse eingesetzt. Inzwischen machen jedoch die Grenzen der optischen Auflösung weitere Fortschritte zunehmend schwieriger.

Für die zukünftig erforderlichen gesteigerten Packungsdichten setzt man daher heute zunehmend auf eine Lithographietechnik, die ohne Lichtstrahlung auskommt, insbesondere auf Elektronen- und Röntgenstrahbelichtungsverfahren. Probleme dieser Art und mögliche Lösungen dafür werden eingehender behandelt in dem Artikel von B. L. Critchlow mit dem Titel « High Speed MOSFET circuits Using Advanced Lithography », veröffentlicht in der Zeitschrift Computer, Band 9, Nr. 2, Februar 1976, Seiten 31 bis 37. In diesem Artikel kommen insbesonders die erheblichen Kosten für die erforderliche Apparatur sowie die Komplexität der Röntgen- und Elektronenstrahllithographie zum Ausdruck. Bisher besteht jedoch die Auffassung, daß diese Techniken die einzigen Alternativen für die optische Projektionsbelichtung für derart hochkomplexe integrierte Schaltkreise der zukünftig benötigten Art darstellen.

Darüber hinaus gab es weitere Bemühungen, sehr schmale Linienbreitenim Bereich von 1 μm oder darunter durch Ausweitung der standardmäßigen photolithographischen Verfahren unter Vermeidung derart kostenträchtiger und komplexer Techniken wie Elektronen- oder Röntgenstrahllithographie zu erzielen. Ein möglicher Lösungsweg ist beispielsweise in der Veröffentlichung im IBM Technical Disclosure Bulletin, Vol. 19, No. 6, November 1976, Seiten 2 057/2 058 unter dem Titel « Narrow Line Widths Masking Method » beschrieben. Das dort behandelte Verfahren macht von porösem Silicium und einem zugehörigen Oxidationsprozeß Gebrauch. Ein anderes Verfahren ist in der Veröffentlichung im IBM Technical Disclosure Bulletin Vol. 20, No. 4, September 1977 auf den Seiten 1 376 bis 1 378 beschrieben. Dort werden polykristalline Maskierungsschichten aus Silicium benutzt, wobei die Maskenausbildung unter Einsatz einer Zwischenmaskierung aus einem oxidationshemmenden Material, z.B. im Fall von polykristallinem Silicium aus Siliciumnitrid, erfolgt. Mit diesem Verfahren lassen sich Linienbreiten unterhalb 2 μm erzielen.

Ferner steht in der Technik des Plasma- oder reaktiven Ionenätzens eine zum Ätzen von Metallen, halbleitenden und dieletrischen Materialien für integrierte Schaltkreise entwickelte Technik mit guten Eigenschaften zur Verfügung. Insbesondere läßt sich mit dem reaktiven Ionenätzen ein anisotropisches Ätzen durchführen, mit dem hohe sog. Aspektverhältnisse erzielbar sind, d.h. die Ätzrate in vertikaler Richtung ist erheblich stärker ausgeprägt als die in horizontaler Richtung. Für die Prozeßdurchführung wird ein Plasma bzw. ionisiertes Gas benötigt, für das eine Vielzahl von hoch-reaktiven Bestandteilen, z. B. Ionen, freie Elektronen und freie Radikale, maßgeblich sind. Das zum Ätzen eingesetzten Plasma kann auf relativ niedrigen Temperaturen in der Größenordnung bis etwa 250 °C und bei geringen Drucken im Bereich von 0,005 bis 20 Torr (etwa 0,006 bis 27 mbar) gehalten werden. Die Plasma-Bestandteile sind überwiegend freie Radikale, die die intensive Reaktivität des Plasmas bewirken. Die Ionenbesetzung in einem Plasma von niedriger Temperatur beträgt größenordnungsmäßig etwa 1 % der Bestandteile. In dem Artikel « A Survey of Plasma-Etching Processes », von Richard L. Bersin, veröffentlicht in der Zeitschrift Solid State Technology, Mai 1976, Seiten 31 bis 36 ist sehr eingehend, das Plasmaätzen sowie dessen Anwendung auf halbleitende Materialien behandelt. Ein solcher Prozeß wurde auch bereits eingesetzt, um Gräben oder Öffnungen in Silicium-Halbleiterkörpern auszubilden, vgl. z. B. die US-Patentschriften 3 966 577 (A. K. Hochberg), 4 104 086 (J. A. Bondur sowie 4 139 442 (J. A. Bondur u. a.). Weitere Einzelheiten über die Technologie des reaktiven Ionenätzens bzw. Plasmaätzens können der DE-Offenlegungsschrift 26 17 483 (J. N. Harvilchuck u. a.) entnommen werden. Das von Harvilchuck angegebene HFinduzierte Plasma benutzt als Bestandteil reaktives Chlor, Brom oder Jod. In der zuletzt genannten Schrift findet sich auch eine nähere Beschreibung der HF-Entladekammer zur Durchführung des Verfahrens sowie der einzelnen Prozeßbedingungen.

Ein besonderes Problem bei sehr hoch integrierten Schaltkreisen besteht in der Ausbildung der elektrischen Anschlüsse bzw. Kontakte zu den verschiedenen Elementen der integrierten Schaltkreise. Bei der sehr großen Anzahl solcher Element müssen für die Ausbildung der Anschlüsse und Verbindungen inzwischen Mehrfachlagen mit zwei bis vier oder noch mehr Leitebenen auf dem Schaltkreis vorgesehen werden. Dabei ist es überdies notwendig, alle Leitungen in solchen Mehrlagenanordnungen zuverlässig voneinander zu isolieren. Der Aufbau solcher Mehrlagenverbindungen auf der Oberfläche eines Halbleiterkörpers bringt weiterhin Planaritätsprobleme mit sich, die insbesondere im Hinblick auf die Lithographie-verfahren Defekt-Ursachen darstellen können. Beispiele solcher Mehrlagenstrukturen in integrierten Schaltkreisen unter Verwendung von hochdotiertem polykristallinen Silicium für die Leitebenen sind beispielsweise behandelt in den US-Patentschriften 3 750 268, 3 984 822, 3 996 657, 3 943 543 und 4 097 885.

Bei den üblichen Verfahren zur Herstellung von Doppellagen aus polykristallinem Silicium als Leitmaterial wird Siliciumdioxid als diese Leitschichten trennende Isolierschicht verwendet. Die Dicke der zwischen zwei derartigen Lagen vorgesehenen Siliciumdioxidschicht ist normalerweise gleich der Dicke der Gate-Oxidschicht im Falle einer herzustellenden FET-Struktur. Dabei wird das Siliciumdioxid mittels üblicher thermischer Oxidation gebildet.

Die Erfindung, wie sie in den Patentansprüchen gekennzeichnet ist, löst die Aufgabe, für den Aufbau hochintegrierter Halbleiteranordnungen verbesserte Verfahren zur Herstellung einer derartige Leitschichten und insbesondere deren vertikale (Seiten-) Flächen bedeckenden Isolierschicht mit jeder gewünschten Dicke anzugeben.

Zusammengefaßt sieht die Erfindung dazu ein Verfahren vor, das dadurch gekennzeichnet ist, daß auf den vor dem Aufbringen der Isolierschicht vorliegenden horizontalen Oberflächen eine isolierende Deckschicht aufgebracht wird, daß die Isolierschicht einem reaktiven Ionenätzverfahren derart unterzogen wird, daß im wesentlichen die horizontalen Bereiche der Isolierschicht abgetragen und schmale vertikal gerichtete Bereiche der Isolierschicht auf der Unterlage verbleiben und die isolierende Deckschicht bestehen bleibt, und daß zumindest über diesen verbleibenden vertikalen Isolierschichtbereichen später eine zweite leitende Schicht ausgebildet wird. Je nach Wahl der ursprünglichen Schichtdicke der Isolierschicht lassen sich unterschiedliche Seitenabstände einstellen.

Die Erfindung wird im folgenden anhand von Ausführungsbeispielen unter Zuhilfenahme der Zeichnungen näher erläutert.

Es zeigen :

Figuren 1 bis 5   die Herstellung einer zwischen leitfähigen Schichten vorgesehenen Isolierschicht für einen integrierten Schaltkreis in Bipolartechnik und

Figuren 6 bis 13   einen Verfahrensablauf zur Bildung einer zwischen leitfähigen Schichten angeordneten Isolierschicht für einen Speicherschaltkreis mit wahlfreiem Zugriff in FET-Technologie.

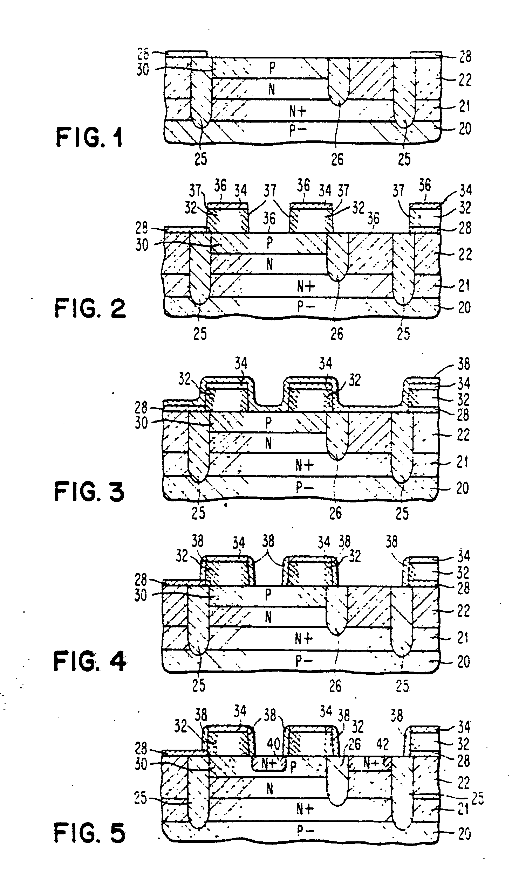

Anhand der Fign. 1 bis 5 soll zunächst auf die Verfahrenschritte zur Herstellung einer bipolaren Transistorstruktur eingegangen werden, bei der unter Anwendung der Erfindung eine Isolierschicht zwischen leitenden Schichten hergestellt wird. Fig. 1 zeigt in starker Vergrößerung einen kleinen Ausschnitt aus einem Siliciumkörper, der zum Aufbau einer hochintegrierten bipolaren Schaltung benutzt wird. In einem P- Substrat 20 aus einkristallinem Silicium ist ein durchgehendes N+ Subkollektordotierungsgebiet 21 vorgesehen. Darüber wurde eine N-Epitaxieschicht 22 aufgewachsen. Bei den hierzu erforderlichen Verfahrensschritten handelt es sich um Standardverfahren, die allgemein bei der Herstellung von beispielsweise NPN-Bipolartransistoren üblich sind. Das Substrat besteht dabei typisch aus Silicium mit einer kristallographischen < 100 >-Orientierung sowie einem spezifischen Widerstandswert in der Größenordnung von 1 bis 20 Ω.cm. Der Subkollektor wird typischerweise durch eine Arsendiffusion mit einer Oberflächenkonzentration von etwa $10^{20}$ Atomen/cm$^3$ hergestellt. Der Epitaxieprozeß zur Herstellung der Epitaxieschicht 22 kann ebenfalls konventionell ausgestaltet sein, z. B. unter Verwendung von $SiCl_4/H_2$- oder $SiH_4/H_2$-Mischungen bei Temperaturen von etwa 1 000 bis 1 200 °C. Während der Bildung der Epitaxieschicht wandern die in der N+ Schicht enthaltenen Dotierungsatome in diese Epitaxieschicht. Die Dicke der Epitaxieschicht beträgt für hochintegrierte Schaltkreise größenordnungsmäßig etwa 3 μm oder weniger. Auf die Oberfläche der Epitaxieschicht 22 wird anschließend eine Maskierungsschicht, z. B. in Form einer thermisch aufgewachsenen Siliciumdioxidschicht, aufgebracht und mittels geeigneter Photolithographie- und Ätzverfahren mit Maskenöffnungen darin ausgestattet.

Die nächsten Verfahrensschritte betreffen dann die Ausbildung von Isolationsbereichen zur gegenseitigen Isolation der einkristallinen Siliciumgebiete. Für diese Isolation können in Sperrichtung vorgespannte PN-Übergänge sowie eine teilweise oder auch vollständige dielektrische Isolation vorgesehen werden. Als dielektrische Materialien kommen Siliciumdioxid, Glas usw. in Frage. Die vorzuziehende Isolationsart für hochdichte integrierte Schaltkreise benutzt dielektrische Isolationsgebiete. Die in Fig. 1 illustrierte Anordnung zeigt eine teilweise dielektrische Isolation mit Isolationsgebieten 25 zur Isolation der jeweils einkristallinen Bereiche des Siliciumkörpers sowie mit einem mit 26 bezeichneten Isolationsgebiet, das den Basis/Emitterbereich von dem Kollektoranschlußbereich trennt. Zur Ausbildung dieser Art von dielektrischer Isolation stehen zahlreiche Möglichkeiten zur Verfügung, vorzugsweise z. B. die in der eingangs erwähnten US-Patentschrift 4 104 086 im einzelnen beschriebene Methode, die sich zur Bildung der mit 25 und 26 bezeichneten Gebiete von Fig. 1 vorteilhaft anwenden läßt.

Auf der Oberfläche des Siliciumkörpers wird anschließend eine Isolierschicht 28 gebildet, die beispielsweise aus thermisch aufgewachsenem Siliciumdioxid bestehen kann. Es kann auch eine andere Schicht oder eine Kombination anderer bekannter Isoliermaterialien zusätzlich zum thermischen Siliciumdioxid verwendet werden, z. B. Siliciumnitrid, Aluminiumtrioxid oder dgl. Im Falle der thermischen Bildung der Isolierschicht 28 wird das Siliciumdioxid in einer Sauerstoff oder Sauerstoff-Wasserdampf enthaltenden Atmosphäre bei einer Temperatur von etwa 970° gebildet. Eine zweite Methode zum Aufwachsen der Schicht aus Siliciumdioxid besteht in dem Einsatz eines chemischen Niederschlagverfahrens aus der Dampfphase, wobei $SiH_4$ und $O_2$ bei etwa 450 °C oder $SiH_2Cl_2$ und $N_2O$ bei einer Temperatur von etwa 800 °C unter Atmosphärendruck oder niedriger zur Anwendung kommen. Das Aufbringen von Siliciumnitrid erfolgt gewöhnlich ebenfalls durch chemischen Niederschlag aus der Dampfphase unter Vorsehung der folgenden Prozeßbedingungen : $SiH_4$, $NH_3$ und $N_2$ Trägergas bei einer Temperatur von etwa 800 °C unter atmosphärischem oder niedrigerem Druck, vgl. z. B. auch US-Patentschrift 4 089 992.

Zur Herstellung von Öffnungen in der Isolierschicht 28 werden standardmäßige Photolithographie- und Ätzverfahren eingesetzt. Die Öffnungen in der Schicht 28 befinden sich an den Stellen, an denen die Basisgebiete der Bipolartransistoren zu liegen kommen sollen. Beschrieben wird im folgenden die Herstellung eines NPN-Transistors ; bei Wahl der entgegengesetzten Leitfähigkeitstypen läßt sich auf diese Weise jedoch gleichermaßen auch ein PNP-Transistor aufbauen. Im Falle eines NPN-Transistors wird das Basisgebiet 30 mittels konventioneller Diffusion oder Ionenimplantation dotiert. Vorgezogen wird dabei, daß das Basisgebiet direkt in der in Fig. 1 gezeigten Weise an die dielektrischen Isolationsgebiete anstößt. Darauf wird die Schicht 28 auch über dem für das Kollektoranschlußgebiet vorgesehenen Bereich mittels üblicher Lithographie- und Ätzverfahren entfernt, so daß sich die in Fig. 1 gezeigte Struktur ergibt. Nun wird ein mit 32 bezeichneter Überzug aus P-dotiertem polykristallinem Silicium über die gesamte Anordnung aufgebracht, wobei man eine Mischung von Silan und Diboran in einer Wasserstoffatmosphäre bei einer Temperatur im Bereich von 500 bis 1 000 °C verwendet. Alternativ kann die polykristalline Siliciumschicht auch zunächst niedergeschlagen und erst anschließend mittels eines Ionenimplantationsschrittes dotiert werden. Gleichermaßen können auch andere P-dotierende Stoffe Anwendung finden. Eine zweckmäßige Schichtdicke des polykristallinen Siliciums beträgt etwa 100 bis 1 000 nm bei einer vorzugsweisen Schichtdicke von 400 nm. Bei Schichtdicken größer als 1 000 nm entstehen Planaritätsprobleme, die die weitere Fabrikation hochdichter integrierter Schaltungsplättchen erschweren. Bei Schichtdicken unterhalb 100 nm kommt der Widerstand der polykristallinen Siliciumschicht bereits stark zur Geltung und beeinflußt negativ die Leistungsdaten des zugehörigen Bauelements. Der vorzugsweise Dotierungsgrad liegt zwischen etwa $10^{19}$ und $10^{21}$ Atomen/$cm^3$. Diese polykristalline Siliciumschicht stellt einen elektrischen Kontakt zum Basisgebiet dar, wobei alle anderen Bereiche auf der Siliciumdioxid-Maskierungsschicht 28 liegen. Mittels Photolithographie- und Ätzverfahren wird die polykristalline Siliciumschicht 32 in den für das Kollektoranschlußgebiet vorgesehenen Bereichen entfernt. Darüber hinaus kann die Schicht 32 auch beispielsweise in für Verdrahtungskanäle oder Schottky-Dioden vorgesehenen Bereichen entfernt werden.

Die soweit behandelte Anordnung wird anschließend in eine Sauerstoff oder Sauerstoff/Wasserdampf enthaltende Atmosphäre eingebracht, um auf der Oberfläche der polykristallinen Siliciumschicht die Siliciumdioxidschicht 34 zu bilden. Dieser thermische Oxidationsprozeß läuft tpyisch bei einer Temperatur von etwa 970 °C ab. Mittels standardmäßiger Photolithographie- und Ätzverfahren werden in diese Siliciumdioxidschicht 34 über den für die Emitter- und Kollektoranschlußgebiete vorgesehenen Bereichen Öffnungen hergestellt. Die Schichtdicke der Siliciumdioxid-Maskierung beträgt typisch etwa 200 bis 2 000 nm. Anschließend wird die Struktur zur reaktiven Ionen- oder Plasmaätzung des polykristallinen Siliciums in eine wie folgt zusammengesetzte Prozeßatmosphäre eingebracht und behandelt : z. B. $Cl_2$-Argon oder $CCl_4$-Argon, bei 10 µm Druck in einer HF-Parallelelektrodeneinrichtung mit einer Leitsungsdichte von 0,16 W/$cm^2$ und einer Durchflußrate von 10 $cm^3$/min unter Verwendung einer Apparatur, auf die eingangs Bezug genommen wurde. Der Vorgang des reaktiven Ionenätzens ist abgeschlossen, wenn das einkristalline Silicium erreicht wird. Die daraus resultierende Struktur ist in Fig. 2 dargestellt, wobei die Emitter- und Kollektoranschlußöffnung in der resultierenden Struktur die mit 36 bezeichneten horizontalen sowie die mit 37 bezeichneten vertikalen Oberflächen bilden. Eine diese Oberfläche nachzeichnende Isolierschicht 38 wird dann sowohl auf die im wesentlichen horizontalen als auch auf die im wesentlichen vertikalen Oberflächen niedergeschlagen. Diese Schicht 38 wird in typischen Fällen durch chemischen Niederschlag aus der Dampfphase gebildet. Das Material dieser Schicht 38 kann eines aus einer Vielzahl dafür geeigneter Materialien sein, z. B. Siliciumdioxid, Siliciumnitrid, Aluminiumoxid und Kombinationen aus diesen Schichten.

Fig. 3 zeigt das Ergebnis dieses Verfahrensschrittes. Die Dicke der entsprechenden Schicht 38 ist dabei unter den jeweiligen Anwendungsgesichtspunkten gewählt, z. B. in diesem Fall für die Emitter/Basis-Trennung, sie kann zwischen 50 und 2000 nm und vorzugsweise 400 nm betragen. Die Schichtdicke kann weiterhin von dem jeweilig verwendeten Isolationsmaterial abhängen. Ist die Schichtdicke größer als 2000 nm, werden längere Ätzzeiten erforderlich ; bei Schichtdicken geringer als 50 nm könnte die Gefahr von Kurzschlüssen des Emitterkontakts zum polykristallinen Silicium oder zum Basisgebiet auftreten.

Die in Fig. 3 gezeigte Anordnung wird anschließend in eine zum reaktiven Ionenätzen der Schicht 38 geeignete Prozeßatmosphäre eingebracht. Soll z. B. Siliciumdioxid geätzt werden, ist die Einstellung eines Ätzverhältnisses von etwa 10/1 für $SiO_2/Si$ wünschenswert. Dabei ist ein geringer Grad von Überätzung und/oder ein Ätzende-Indikator erforderlich, um sicher sein zu können, daß das $SiO_2$ vollständig entfernt ist. Dieser reaktive Ionenätzprozeß entfernt im wesentlichen die horizontalen Bereiche der Schicht 38 und beläßt entsprechend Fig. 4 die sehr schmalen Schichtbereiche auf den vertikalen Oberflächenbereichen des Siliciumkörpers.

Als nächstes werden die Dotierungsgebiete für den Emitter 40 und das Kollektoranschlußgebiet 42 vorgesehen. Soll das N+ Emittergebiet 40 und das Kollektoranschlußgebiet 42 mittels thermischer Diffusion eingebracht werden, wird das reaktive Ionenätzen der Schicht 38 bis zum Erreichen der freien Oberfläche des Siliciumgrundkörpers durchgeführt. Der thermische Diffusionsvorgang mit N-Dotierungsstoffen, z. B. Arsen oder Phosphor, kann in für Emitterdiffusionen überlicher Weise und in Abhängigkeit von der gewünschten Eindringtiefe vorgenommen werden, z. B. in einer Arsen-Kapseldiffusion bei 1050 °C. Sollen das Emittergebiet 40 und das Kollektoranschlußgebiet 42 dagegen mittels Ionenimplantation ausgebildet werden, empfiehlt es sich, diese Implantation durch eine dünne Schutzschicht hindurch vorzunehmen. Die Bildung einer solchen Schutzschicht wird einfach dadurch erreicht, daß man das reaktive Ionenätzen nur so weit durchführt, daß in den betreffenden horizontalen Oberflächenbereichen noch eine dünne (nicht gezeigte) Schicht verbleibt. Alternativ kann aber auch diese Isolierschicht zunächst vollständig entfernt und daraufhin durch eine neu aufgewachsene dünne Siliciumdioxidschicht ersetzt werden. Die Anordnung wird dann in eine Ionenimplantationseinrichtung eingebracht, wo Ionen und andere gewünschte Verunreinigungen, z. B. Arsen, Phosphor oder dgl., durch die Schutzschicht in den Halbleiterkörper zur Bildung der Dotierungsgebiete 40 und 42 eingebaut werden. Als Prozeßbedingungen für eine solche Arsenimplantation kommt eine Dosis von $10^{16}$ Atomen/cm³ bei einer Leistung von 100 keV in Frage. Ein zugehöriger Eintreibschritt erfolgt dann bei einer Temperatur von etwa 1050 °C in einer oxidierenden Atmosphäre. Die Ausbildung elektrischer Anschlüsse sowie die Metallisierung kann danach in der Weise durchgeführt werden, daß für die Anschlüsse P+ Silicium eingesetzt und Aluminium aufgedampft wird, wobei die jeweilige Formgebung wieder mit den üblichen Lithographie- und Ätzverfahren vorgenommen wird.

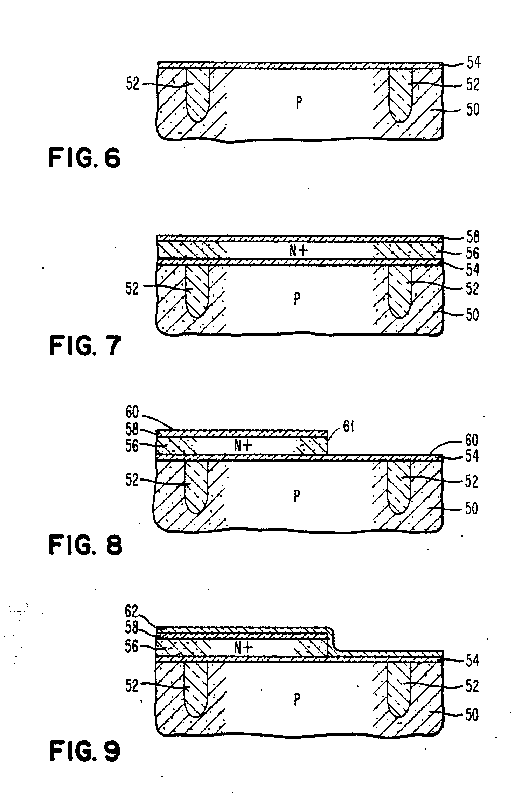

Anhand der Fign. 6 bis 13 soll im folgenden ein mit Feldeffekttransistoren (FET) aufgebauter integrierter Schaltkreis für einen Speicher mit wahlfreiem Zugriff näher erläutert werden. Entsprechend Fig. 6 wird von einem P-leitenden Substrat 50 mit einem spezifischen Widerstandswert von 10 $\Omega$ cm ausgegangen. Mittels eines dielektrischen Isolationsmusters 52 ist das Substrat in Teilbereiche abgeteilt. In jeden der Bereiche soll eine einzelne Speicherzelle der Speicheranordnung vorgesehen werden. Die sog. Gate-Isolierschicht 54 wird auf die Oberfläche des Substrats 50 niedergeschlagen. Diesen Gate-Isolierschicht 54 kann sich aus einer Vielzahl von Isolierstoffen zusammensetzen, wozu insbesondere Siliciumdioxid, Siliciumnitrid und Kombinationen dieser Schichten zählen. Vorzuziehen ist jedoch eine Siliciumdioxidschicht, die zudem mittels thermischer Verfahren gebildet wird. Die Schichtdicke der Gate-Isolierschicht liegt vorzugsweise unterhalb 100 nm.

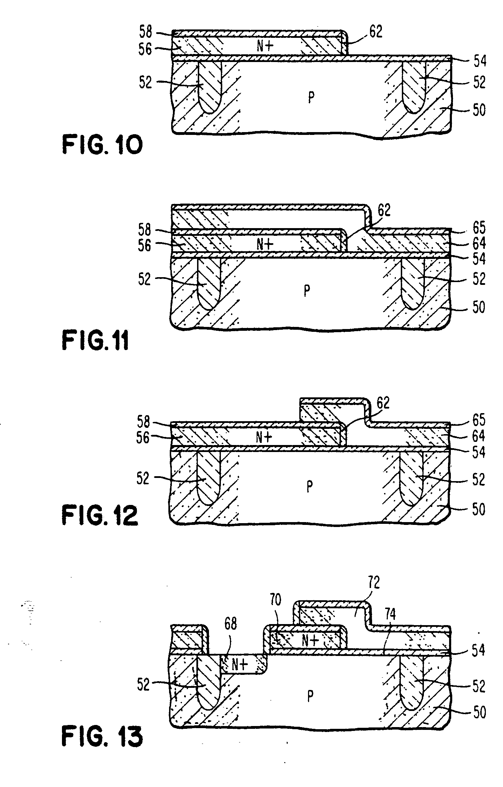

Über die Gate-Oxidschicht 54 wird eine erste Schicht 56 aus polykristallinem Silicium aufgebracht. Dieses polykristalline Silicium ist mit Phosphor N+ dotiert. Es wird mittels chemischen Niederschlags aus der Gasphase durch Zersetzung von $SiH_4$ bei etwa 600 °C unter atmosphärischem oder niedrigerem Druck erzeugt. Die Dicke dieser polykristallinen Siliciumschicht liegt zwischen etwa 100 und 1000 nm, vorzugsweise bei 400 nm. Die soweit hergestellte Anordnung wird anschließend in einer Sauerstoff- oder Sauerstoff/Wasserdampfatmosphäre bei 970 °C zur thermischen Bildung einer zweiten Siliciumdioxidschicht 58 auf der polykristallinen Siliciumschicht 56 weiterbehandelt. Alternativ kann diese Silicium-dioxidschicht auch mittels chemischer Aufdampfung gebildet werden. Die daraus resultierende Struktur ist in Fig. 7 gezeigt. In dieser zweiten Isolierschicht 58 werden dann mittels standardmäßiger Photolithographie- und Ätzverfahren Öffnungen hergestellt. Die Öffnungen liegen dabei über den Gebieten in den Zellbereichen, wo letztlich die Speicherelektrode gebildet werden soll. Mittels reaktivem Ionenätzen wird die erste polykristalline Siliciumschicht 56 im Bereich dieser Öffnungen der Schicht 58 geätzt. Durch diesen Ätzschritt wird die Transfer-Elektrode teilweise definiert. Als weiteres Ergebnis dieses reaktiven Ionenätzens liegen entsprechend Fig. 8 im wesentlichen horizontale Oberflächen 60 sowie im wesentlichen vertikale Oberflächen 61 auf dem Halbleiterkörper vor. Auf beide Oberflächenarten wird nun eine entsprechend sich anpassende Isolierschicht 62 aufgebracht. Bei dieser Schicht handelt es sich um eine Isolierschicht, wie sie in dem zuvor beschriebenen Ausführungsbeispiel angegeben wurde, wobei sich auch diese Schicht wieder aus einer Vielzahl von Isoliermaterialien zusammensetzen kann. Die Dicke dieser Schicht definiert die vertikale Isolierschicht zwischen den leitfähigen Schichten in der endgültigen FET-Struktur. Die Schichtdicke liegt vorzugsweise zwischen 100 und 500 nm und vorzugsweise bei etwa 200 nm. Für die jeweilige Isolierschicht wird dann erneut ein reaktiver Ionenätzschritt durchgeführt, um die horizontalen Schichtanteile der Isolierschicht 62 zu entfernen, während auf den vertikalen Oberflächen 61 der ersten polykristallinen Siliciumschicht sehr klein dimensionierte vertikale Isolierschichtbereiche verbleiben. Die bis hierher erzielte Struktur zeigt Fig. 10.

Anschließend wird eine zweite mit 64 bezeichnete Schicht aus polykristallinem Silicium oder einem ähnlichen leitfähigen Material über die Oberfläche der Struktur niedergeschlagen, d. h. auf die vertikal angeordneten Isolierschichtbereiche 62 sowie die die erste polykristalline Siliciumschicht bedeckende Isolierschicht 58. Eine dritte Isolierschicht 65 wird sodann wieder auf der zweiten polykristallinen Siliciumschicht 64 aufgebracht, wobei die weiter oben dazu angegebenen Verfahren erneut eingesetzt werden können.

Ein Teil dieser dritten Isolierschicht 65 sowie der zweiten polykristallinen Siliciumschicht 64 werden dann entfernt, um das für die Verbindungen der Feldeffektelemente erforderliche Muster vorzusehen. In gleicher Weise werden mittels geeigneter Ätzverfahren die zweite Isolierschicht 58 und die erste polykristalline Siliciumschicht 56 in einem vorgegebenen Muster entfernt, um Öffnungen bis zum Siliciumsubstrat 50 für die Ausbildung der Dotierungsgebiete zu erhalten. Wie aus Fig. 13 hervorgeht, wird anschließend mittels Diffusion das N+ Dotierungsgebiet 68 für die Speicherzelle erzeugt, wobei dieses Dotierungsgebiet 68 alternativ auch durch eine Ionenimplantation in der weiter oben erläuterten Weise durch eine Siliciumdioxid-Schutzschicht gebildet werden kann.

In dem hier beschriebenen Ausführungsbeispiel bildet die in Fig. 13 gezeigte Struktur ein FET-Element für eine Speicherzelle mit wahlfreiem Zugriff. Das Dotierungsgebiet 68 dient dabei als Bitleitung. Die Silicium-Gate-Elektrode ist mit 70 bezeichnet und dient als Wortleitung. Der Kanal des Feldeffekttransistors befindet sich unterhalb des Gate-Bereichs 70. Das polykristalline Gebiet 72 stellt eine Elektrode für die Kapazität 74 der Speicherzelle dar, während das Substrat die andere Elektrode bildet. Die Elektrode 72 wird an eine Gleichspannungsquelle angeschlossen.

Die Siliciumdioxidschicht im sog. Transfer-Bereich kann dabei eine gegenüber der Siliciumdioxidschicht im Speicherbereich unterschiedliche Dicke aufweisen. Das kann beispielsweise in der Form geschehen, daß man beim in Fig. 7 veranschaulichten Verfahrensschritt eine gegenüber der Schicht 54 wesentlich dickere Siliciumdioxidschicht 58 aufwachsen läßt. Entsprechend Fig. 8 werden die beiden Schichten 54 und 58 einem reaktiven Ätzprozeß unterworfen, bis die freiliegenden Schichtbereiche der Schicht 54 entfernt sind. Dabei wird auch ein Teil der Siliciumdioxidschicht 58 abgetragen, wobei jedoch für die jeweilige Funktion genügend Siliciumdioxid stehen bleibt. Mittels konventioneller Verfahren wird anschließend das Siliciumdioxid der Schicht 54 wieder auf die gewünschte Dicke gebracht.

Dieses Verfahren kann überall dort Anwendung finden, wo man die Schichtdicke für die vertikale Isolierschicht unabhängig von der Schichtdicke für die horizontale Isolierschicht auf der Oberfläche der Silicium-Halbleiteranordnung einstellen möchte. Anwendung kann dieses Verfahren beispielsweise für die Herstellung von Ladungskopplungsschaltungen sowie von FET-Logikschaltkreisen finden.

### Ansprüche

1. Verfahren zur Herstellung einer Schichtstruktur für hochintegrierte Halbleiteranordnungen, bei dem jeweils eine Isolierschicht zur Trennung zweier leitender Schichten auf einer Unterlage vorzusehen ist, bei dem zunächst auf der Oberfläche der Unterlage Bereiche einer ersten leitenden Schicht (32, 56) ausgebildet werden, so daß im wesentlichen horizontale sowie im wesentlichen vertikale Oberflächen (36, 37 bzw. 60, 61) entstehen, und bei dem auf diese im wesentlichen horizontalen sowie im wesentlichen vertikalen Oberflächen eine diese bedeckende und sich daran anpassende Isolierschicht (38, 62) aufgebracht wird, dadurch gekennzeichnet, daß auf den vor dem Aufbringen der Isolierschicht (38, 62) vorliegenden horizontalen Oberflächen eine isolierende Deckschicht (34, 58) aufgebracht wird, daß die Isolierschicht einem reaktiven Ionenätzverfahren derart unterzogen wird, daß im wesentlichen die horizontalen Bereiche der Isolierschicht abgetragen werden und schmale vertikal gerichtete Bereiche der Isolierschicht auf der Unterlage verbleiben und die isolierende Deckschicht (34, 58) bestehen bleibt, und daß zumindest über diesen verbleibenden vertikalen Isolierschichtbereichen später eine zweite leitende Schicht ausgebildet wird.

2. Verfahren nach Anspruch 1, dadurch gekennzeichnet, daß es sich bei der Unterlage um einen Halbleiterkörper aus einkristallinem Silicium handelt.

3. Verfahren nach Anspruch 2, dadurch gekennzeichnet, daß in dem Halbleiterkörper, vorzugsweise durch dielektrische Trenngebiete (25, 26, 52) isolierte, Bipolar- oder FET-Strukturen ausgebildet sind, deren Anschlußverbindungen über die erste und/oder zweite leitende Schicht durchgeführt werden.

4. Verfahren nach einem der vorhergehenden Ansprüche, dadurch gekennzeichnet, daß die erste und/oder zweite leitende Schicht aus polykristallinem Silicium besteht und vorzugsweise die Bereiche der ersten leitenden Schicht (32) Basiskontakte von Bipolartransistoren bilden, wobei im Falle von NPN-Transistoren das polykristalline Silicium P- dotiert ist.

5. Verfahren nach Anspruch 1, dadurch gekennzeichnet, daß die isolierende Deckschicht (34, 58) aus thermisch aufgewachsenem Siliciumdioxid hergestellt wird.

6. Verfahren nach einem der vorhergehenden Ansprüche, dadurch gekennzeichnet, daß die Isolierschicht (38, 62) aus Siliciumdioxid besteht und vorzugsweise thermisch aufgewachsen oder chemisch aus der Gasphase niedergeschlagen wird.

7. Verfahren nach einem der vorhergehenden Ansprüche, dadurch gekennzeichnet, daß die Schichtdicke der Isolierschicht (38, 62) bzw. der davon verbleibenden vertikal gerichteten Bereiche etwa 100 bis 1 000 nm beträgt.

8. Verfahren nach einem der vorhergehenden Ansprüche zur Herstellung von Bipolar-Transistorstrukturen, gekennzeichnet durch folgende Verfahrensschritte (Fign. 1 bis 5) :

a) in einem Halbleiterkörper werden voneinander vorzugsweise durch dielektrische Trennzonen (25) isolierte einkristalline Bereiche abgegrenzt ;

b) in den einkristallinen Bereichen wird jeweils ein Basisgebiet (30) erzeugt ;

c) auf der Oberfläche des Halbleiterkörpers wird eine Maskierungsschicht (28) mit Öffnungen an den für die Basiskontakte vorgesehenen Stellen ausgebildet ;

d) über der Maskierungsschicht wird zunächst als erste leitende Schicht eine Schicht (32) aus polykristallinem Silicium niedergeschlagen und mit der isolierenden Deckschicht (34) versehen ;

e) die Deckschicht (34) sowie die polykristalline Siliciumschicht (32) werden sodann an den für die Emitter- und Kollektoranschlußgebiete vorgesehenen Stellen entfernt, wobei die im wesentlichen horizontalen sowie die im wesentlichen vertikalen Oberflächenbereiche (36, 37) entstehen ;

f) auf diesen Oberflächenbereichen (36, 37) wird die diese bedeckende und sich formmäßig daran anpassende Isolierschicht (38) gebildet ;

g) die Isolierschicht (38) wird sodann einem reaktiven Ionenätzverfahren derart unterzogen, daß im wesentlichen die die horizontalen Oberflächen (36) bedeckenden Bereiche der Isolierschicht (38) abgetragen werden und schmale Bereiche der Isolierschicht (38) auf den vertikalen Oberflächen der polykristallinen Siliciumschicht (32) verbleiben ;

h) in den so freiliegenden Bereichen des Halbleiterkörpers werden die für Emitter- und Kollektoranschlußgebiete (40 und 42) erforderlichen Dotierungen vorgenommen und darüber eine zweite leitende Schicht ausgebildet.

9. Verfahren nach Anspruch 8, dadurch gekennzeichnet, daß Basis- und Kollektoranschlußgebiete (30, 42) jeweils durch dielektrische Gebiete (26) voneinander getrennt sind.

10. Verfahren nach einem der Ansprüche 1 bis 7 zur Herstellung von FET-Strukturen, gekennzeichnet durch folgende Verfahrensschritte (Fig. 6 bis 13) :

a) auf der Oberfläche eines einkristallinen Silicium-Halbleiterkörpers wird in an sich bekannter Weise eine als Gate-Dielektrikum geeignete Schicht (54) aufgebracht ;

b) darüber wird zunächst die erste leitende Schicht (56) aus polykristallinem Silicium niedergeschlagen und mit einer ersten isolierenden Deckschicht (58) versehen ;

c) die erste Deckschicht (58) sowie die erste polykristalline Siliciumschicht (56) werden sodann bereichsweise zur Formung der Gate-Elektrode entfernt, wobei die im wesentlichen horizontalen sowie die im wesentlichen vertikalen Oberflächenbereiche (60, 61) entstehen ;

d) auf diesen Oberflächenbereichen (60, 61) wird die diese bedeckende und sich formmäßig daran anpassende Isolierschicht (62) gebildet ;

e) die Isolierschicht (62) wird sodann einem reaktiven Ionenätzverfahren derart unterzogen, daß im wesentlichen die die horizontalen Oberflächen (60) bedeckenden Bereiche der Isolierschicht (62) abgetragen werden und schmale Bereiche der Isolierschicht (62) auf den vertikalen Oberflächen der polykristallinen Siliciumschicht (56) verbleiben ;

f) darüber wird eine zweite Schicht (64) aus polykristallinem Silicium niedergeschlagen und mit einer zweiten isolierenden Deckschicht (65) versehen ;

g) die zweite Deckschicht (65) sowie die zweite Schicht (64) aus polykristallinem Silicium werden sodann bereichsweise zur Abgrenzung des elektrischen Verbindungsmusters der Feldeffektelemente untereinander entfernt ;

h) an den für Dotierungsgebiete (68) vorgesehenen Stellen werden sodann ferner die erste Deckschicht (58) sowie die erste Schicht (56) aus polykristallinem Silicium entfernt und die entsprechenden Dotierungsmaßnahmen vorgenommen.

11. Verfahren nach Anspruch 10, dadurch gekennzeichnet, daß eine Halbleiteranordnung für integrierte Speicherzellen hergestellt wird, wobei die Gate-Elektroden (70) als Transfer-Elektroden die Wortauswahlleitungen und die Dotierungsgebiete (68) die Bitauswahlleitungen darstellen und durch den Verfahrensschritt g) die Speicher-Elektroden gebildet werden.

12. Verfahren nach einem der Ansprüche 10 bis 11, dadurch gekennzeichnet, daß die als Gate-Dielektrikum geeignete Schicht (54) sowie die erste und zweite Deckschicht (58, 65) aus thermisch aufgewachsenem und die Isolierschicht (62) aus chemisch aus der Gasphase und mit einer Dicke von 100 bis 500 nm niedergeschlagenem Siliciumdioxid gebildet werden.

13. Verfahren nach einem der Ansprüche 10 bis 12, dadurch gekennzeichnet, daß im Halbleiterkörper gegeneinander vorzugsweise durch dielektrische Gebiete (52) isolierte einkristalline Bereiche abgegrenzt sind, in denen jeweils die Elemente eines Feldeffekttransistors gebildet werden.

## Claims

1. Method of making a layer structure for highly integrated semiconductor arrangements, where one respective insulation layer is to be provided to separate two conductive layers on a substrate, where first on the substrate surface regions of a first conductive layer (32, 56) are made so that substantially horizontal and substantial vertical surfaces (36, 37 and 60, 61) are formed, and where onto these substantially horizontal and substantially vertical surfaces an insulation layer (38, 62) covering them and adapting thereto is provided, characterized in that onto the horizontal surfaces existing prior to the application of the insulation layer (38, 62) an insulating covering layer (34, 58) is applied, that the insulation layer is exposed to a reactive ion etching process in such a manner that substantially the horizontal regions of the insulation layer are removed and narrow vertical regions of the insulation layer remain on the substrate, and the insulation covering layer (34, 58) remains, and that at least over these remaining vertical insulation layers a second conductive layer is later applied.

2. Method as claimed in claim 1, characterized in that the substrate is a semiconductor body of monocrystalline silicon.

3. Method as claimed in claim 2, characterized in that in the semiconductor body, preferably through dielectric separating regions (25, 26, 52), insulated bipolar or FET structures are designed whose connections are effected via the first and/or second conductive layer.

4. Method as claimed in any one of the preceding claims, characterized in that the first and/or second conductive layer consists of polycrystalline silicon, and that preferably the regions of the first conductive layer (32) form base contacts of bipolar transistors, the polycrystalline silicon being P-doped if NPN-transistors are involved.

5. Method as claimed in claim 1, characterized in that the insulation covering layer (34, 58) is made of thermally grown silicon dioxide.

6. Method as claimed in any one of the preceding claims, characterized in that the insulation layer (38, 62) consists of silicon dioxide and is preferably thermally grown, or applied through chemical vapor deposition.

7. Method as claimed in any one of the preceding claims, characterized in that the layer thickness of the insulation layer (38, 62), or of the vertical zones remaining thereof is approximately 100 to 1 000 nm.

8. Method as claimed in any one of the preceding claims for making bipolar transistor structures, characterized by the following process steps (Figs. 1 to 5) :

a) in a semiconductor body, monocrystalline regions preferably insulated from each other by dielectric separating zones (25) are provided ;

b) in the monocrystalline regions one respective base region (30) is generated ;

c) on the surface of the semiconductor body, a masking layer (28) with openings at the base contact spots is provided ;

d) over the masking layer, a layer (32) of polycrystalline silicon is first deposited as a first conductive layer, and coated with the insulation covering layer (34) ;

e) the covering layer (34) as well as the polycrystalline silicon layer (32) are then removed in the locations for the emitter and collector connecting zones, thus forming the substantially horizontal and the substantially vertical surface regions (36, 37) ;

f) onto these surface regions (36, 37) the insulation layer (38) covering them and adapting thereto with respect to form is produced ;

g) subsequently, the insulation layer (38) is subjected to a reactive ion etching process, in such a manner that substantially those regions of the insulation layer (38) which cover the horizontal surfaces (36) are removed, and that narrow zones of the insulation layer (38) remain on the vertical surfaces of the polycrystalline silicon layer (32) ;

h) in the thus exposed regions of the semiconductor body, dopings are made for the emitter and collector connecting regions (40 and 42) are made, and on this a second conductive layer is made.

9. Method as claimed in claim 8, characterized in that base and collector connecting regions (30, 42) are respectively separated from each other through dielectric regions (26).

10. Method as claimed in any one of claims 1 to 7 for making FET structures, characterized by the following process steps (Figs. 6 to 13) :

a) on the surface of a monocrystalline silicon semiconductor body a gate insulator layer (54) is applied in a manner known per se ;

b) onto this layer, the first conductive layer (56) of polycrystalline silicon is deposited, and coated with a first insulating covering layer (58) ;

c) the first covering layer (58) and the first polycrystalline silicon layer (56) are subsequently removed region-wise to form a gate electrode, so that the substantially horizontal as well as the substantially vertical surface regions (60, 61) are produced ;

d) on these surface regions (60, 61) the insulation layer (62) is produced which covers them and adapts thereto with respect to form ;

e) the insulation layer (62) is subsequently subjected to a reactive ion etching in such a manner that substantially those regions of the insulation layer (62) which cover the horizontal surfaces (60) are removed, and that there remain narrow regions of the insulation layer (62) on the vertical surfaces of the polycrystalline silicon layer (56) ;

f) onto that, a second layer (64) of polycrystalline silicon is deposited and coated with a second insulating covering layer (65) ;

g) the second covering layer (65) as well as the second layer (64) of polycrystalline silicon are removed region-wise to define the electrical pattern among the field effect element ;

h) at the locations for the doping regions (68), the first covering layer (58) as well as the first layer (56) of polycrystalline silicon are subsequently removed, and the corresponding doping steps are carried out.

11. Method as claimed in claim 10, characterized in that a semiconductor arrangement for integrated storage cells is produced, the gate electrodes (70) representing transfer electrodes and word selection lines, and the doping regions (68) representing the bit selection lines, and in that through process step g) the storage electrodes are made.

12. Method as claimed in any one of claims 10 to 11, characterized in that the gate insulation layer (54), as well as the first and second covering layer (58, 65) are made of thermally grown silicon dioxide, and the insulation layer (62) is of silicon dioxide applied by chemical vapor deposition, and with a thickness of 100 to 500 nm.

13. Method as claimed in any one of claims 10 to 12, characterized in that in semiconductor body monocrystalline regions insulated by dielectric regions (52) with respect to each other are provided wherein the respective elements of a field effect transistor are made.

**Revendications**

1. Procédé pour fabriquer une structure multi-couches pour des dispositifs semi-conducteurs à haute densité d'intégration ; dans lequel une couche isolante est utilisée pour séparer deux couches conductrices sur un support, dans lequel des régions d'une première couche conductrice (32, 56) sont d'abord formées sur la surface du support de telle sorte qu'on obtienne des surfaces essentiellement horizontales et verticales (36, 37 ou 60, 61) ; et dans lequel on dépose sur ces surfaces essentiellement horizontales et verticales une couche isolante (38, 62) recouvrant et s'adaptant à celles-ci ; caractérisé en ce qu'on dépose une couche de revêtement isolante (34, 58) sur les surfaces horizontales existant préalablement au dépôt de la couche isolante (38, 62) ; en ce que la couche isolante est soumise à un procédé de décapage par ions réactifs, de telle sorte qu'on décape essentiellement les régions horizontales de la couche isolante pour laisser subsister des régions étroites verticales de la couche isolante sur le support et la couche de revêtement (34, 58) isolante, et en ce qu'on forme ensuite une seconde couche conductrice au moins au-dessus des régions verticales restantes de la couche isolante.

2. Procédé selon la revendication 1, caractérisé en ce que le support est un corps semi-conducteur de silicium monocristallin.

3. Procédé selon la revendication 2, caractérisé en ce qu'on forme dans le corps semi-conducteur, de préférence à travers les régions de séparation diélectriques (25, 26, 52), des structures isolées du type bipolaire ou du type FET, dont les connexions sont établies à travers les première et/ou seconde couches.

4. Procédé selon l'une des revendications précédentes, caractérisé en ce que les première et/ou seconde couches conductrices sont en silicium polycristallin et en ce que de préférence les régions de la première couche conductrice (32) forment les contacts de base de transistors bipolaires ; le silicium polycristallin étant du type P dans le cas des transistors NPN.

5. Procédé selon la revendication 1, caractérisé en ce que la couche de revêtement isolante (34, 58) est en dioxyde de silicium obtenu par croissance thermique.

6. Procédé selon l'une des revendications précédentes, caractérisé en ce que la couche isolante (38, 62) est en dioxyde de silicium déposé de préférence par croissance thermique ou chimiquement en phase gazeuse.

7. Procédé selon l'une des revendications précédentes, caractérisé en ce que l'épaisseur de couche de la couche isolante (38, 62) ou des régions verticales restantes est comprise entre 100 et 1 000 nm.

8. Procédé selon l'une des revendications précédentes, pour fabriquer des structures de transistors bipolaires, caractérisé par les étapes de procédé suivantes (figures 1 à 5) :

a) dans un corps semi-conducteur on définit des régions monocristallines isolées, de préférence séparées par des régions de séparation diélectrique (25) ;

b) dans chacune des régions monocristallines on forme une région de base (30) ;

c) sur la surface du corps semi-conducteur on forme une couche de masquage (28) avec des ouvertures aux emplacements prévus pour les contacts de base ;

d) au-dessus de la couche de masquage on dépose d'abord une couche (32) de silicium polycristallin servant de première couche conductrice ; ladite couche étant recouverte d'une couche de revêtement isolante (34) ;

e) la couche de revêtement (34) et la couche de silicium monocristallin (32) sont ensuite enlevées aux emplacements prévus pour les régions de connexion d'émetteur et de collecteur et on obtient ainsi les régions de surface essentiellement horizontales et verticales (36, 37) ;

f) sur ces régions de surface (36, 37) on forme la couche isolante (38) recouvrant et s'adaptant à celles-ci ;

g) la couche isolante (38) est ensuite soumise à un décapage par ions réactifs de telle sorte qu'on enlève essentiellement les régions de la couche isolante (38) recouvrant les surfaces horizontales et qu'il reste des régions étroites de la couche isolante (38) sur les surfaces verticales de la couche de silicium polycristallin (32) ;

h) dans les régions du corps semi-conducteur ainsi exposées, on effectue le dopage requis pour les régions de connexion d'émetteur et de collecteur (40 et 42) ; et on forme une seconde couche conductrice sur celles-ci.

9. Procédé selon la revendication 8, caractérisé en ce que les régions de connexion de base et de collecteur (30, 42) sont séparées les unes des autres par des régions diélectriques (26).

10. Procédé selon l'une des revendications 1 à 7, pour fabriquer des structures du type FET, caractérisé par les étapes de procédé suivantes (figures 6 à 13) :

a) sur la surface d'un corps semi-conducteur en silicium monocristallin on dépose, de la façon connue, une couche (54) servant de couche diélectrique de porte ;

b) sur cette couche on dépose d'abord la première couche conductrice (56) de silicium polycristallin qui est recouverte d'une première couche de revêtement isolant (58) ;

c) la première couche de revêtement (58) et la première couche de silicium polycristallin (56) sont ensuite enlevées, par région, pour former l'électrode de porte et on obtient ainsi les régions de surface essentiellement horizontales et essentiellement verticales (60, 61) ;

d) sur ces régions de surface (60, 61) on forme la couche isolante (62) recouvrant et s'adaptant à la forme de celles-ci ;

e) la couche isolante (62) est ensuite soumise à un décapage par ions réactifs de telle sorte que les régions de la couche isolante (62) recouvrant les surfaces horizontales sont pratiquement enlevées, ce qui laisse subsister des régions étroites de la couche isolante (62) sur les surfaces verticales de la couche de silicium polycristallin (56) ; -

f) sur celles-ci on dépose une seconde couche (64) de silicium polycristallin recouverte d'une seconde couche de revêtement isolant (65) ;

g) la seconde couche de revêtement (65) et la seconde couche (64) de silicium polycristallin sont ensuite enlevées, région par région, pour définir la configuration des connexions électriques des éléments à effet de champ ;

h) aux emplacements prévus pour les régions de dopage (68) on enlève ensuite la première couche de revêtement (58) ainsi que la première couche (56) de silicium polycristallin pour effectuer les dopages correspondants.

11. Procédé selon la revendication 10, caractérisé en ce qu'on fabrique un dispositif semi-conducteur pour des cellules de mémoire intégrées, dans lequel les électrodes de porte (70) servant d'électrodes de transfert, représentent les lignes de sélection de mots, les régions de dopage (68) représentent les lignes de sélection de bits, et dans lequel les électrodes de mémoire sont formées dans le cours de l'étape de procédé g).

12. Procédé selon l'une des revendications 10 à 11, caractérisé en ce que la couche (54) peut être utilisée comme couche diélectrique de porte, les première et seconde couches de revêtement (58, 65) sont formées d'un dioxyde de silicium obtenu par croissance thermique, et la couche isolante (62) est formée de dioxyde de silicium obtenu chimiquement en phase gazeuse.

13. Procédé selon l'une des revendications 10 à 12, caractérisé en ce que dans un corps semi-conducteur des régions monocristallines sont isolées les unes des autres, de préférence par des régions diélectriques (52), les régions monocristallines servant à former les éléments d'un transistor à effet de champ.

FIG. 1

FIG. 2

FIG. 3

FIG. 4

FIG. 5

FIG. 6

FIG. 7

FIG. 8

FIG. 9

FIG. 10

FIG. 11

FIG. 12

FIG. 13